# EUROPEAN PATENT APPLICATION

(11) **EP 4 727 300 A1**
(43) Date of publication of application: **15.04.2026**
(21) Application number: 24205841.0
(22) Date of filing: 10.10.2024
(51) Int. Cl.: H10F 30/00, G01J 1/42, H10N 60/01

(54) **PHOTODETECTOR DEVICE FOR PHOTODETECTION AT CRYOGENIC TEMPERATURES, METHOD FOR FABRICATING SAID DEVICE, AND ITS USE AT A CRYOGENIC TEMPERATURE**

(71) Applicant: Terra Quantum AG, 9000 St. Gallen (CH)
(72) Inventor: MIRONOV, Alexey, 9000 St. Gallen (CH); VINOKUR, Valerii M., 9000 St. Gallen (CH)
(74) Representative: Lucke, Andreas

(57) **Abstract**

A photodetector device is provided for photodetection when a photosensitive element (2) of the photodetector device has a temperature below 4.2 K. The photodetector device comprises the photosensitive element (2). At least a portion of a surface of the photosensitive element defines an active area (4) of the photodetector device. Electrical contacts (6) are provided to the photosensitive element. The photosensitive element is adapted to provide a current between at least two of the electrical contacts when a photon is absorbed in a section of the photosensitive element underlying the active area. The photodetector device is characterized in that the photosensitive element (2) comprises a superinsulator material.

## Description

### FIELD OF THE DISCLOSURE

The present disclosure relates to a photodetector device and a method for fabricating such a device. Specifically, the present disclosure pertains to a photodetector device utilizing a superinsulator material in its photosensitive element, which operates effectively at cryogenic temperatures below 4.2 K, and the method for producing this photodetector device.

### BACKGROUND

A photodetector comprises a photosensitive element and electrical contacts thereto. The photosensitive element is the core component that reacts to incident photons. Electrical contacts are connected to this element to facilitate the flow of current.

Photodetectors function by converting light (photons) into an electrical signal. When photons strike the photosensitive element, they generate electron-hole pairs, leading to a current or voltage change that can be measured via the electrical contacts.

Photodetectors are crucial in various applications, including optical communication systems, medical imaging, environmental monitoring, and scientific research. In optical communication, they convert light signals into electrical signals for data transmission. In medical imaging, they help in detecting and visualizing tissues. Environmental monitoring uses photodetectors to measure light intensity and detect pollutants. Scientific research benefits from photodetectors in experiments involving light measurement and analysis.

### SUMMARY OF THE DISCLOSURE

It is an object of this invention to provide a photodetector device that overcomes one or more of the disadvantages of known systems and a method for fabricating the same.

According to an aspect of the disclosure, a photodetector device is provided for photodetection when a photosensitive element of the photodetector device has a temperature below 4.2 K. The photodetector device comprises the photosensitive element. At least a portion of a surface of the photosensitive element defines an active area of the photodetector device. Electrical contacts are provided to the photosensitive element. The photosensitive element is adapted to provide a current between at least two of the electrical contacts when a photon is absorbed in a section of the photosensitive element underlying the active area. The photodetector device is characterized in that the photosensitive element comprises a superinsulator material.

The use of the superinsulator material in the photosensitive element makes the photodetector device highly efficient for operation at temperatures below 4.2 K, which are also referred to as cryogenic temperatures in the context of this disclosure.

This is a major advantage over other types of photodetectors, for example based on semiconductors. Photodetectors based on semiconductors are not operable at cryogenic temperatures or show poor performance, with an excessively high response time upon arrival of the photon, and with an excessively long resistance relaxation time, limiting the rate at which incoming photons can be detected, or the maximum photon intensity which can be identified, respectively. Moreover, in semiconductor-based photodetectors, the photocurrent generated at cryogenic temperatures is generally small, making it difficult to detect, thus rendering the measurement of said current and ultimately of the incoming light intensity, which is to be determined, inaccurate.

Superinsulators are materials dual to superconductors. In other words, superinsulators are materials that at low but finite temperatures (for example, at 4.2 K and below or at 2 K and below) provide a superinsulating state. In this superinsulating state, a superinsulator has an essentially infinite resistance so that no electric current can pass through it. The superinsulating state has been observed in titanium nitride films, niobium titanium nitride films, and in indium oxide films. Moreover, US 2021/068320 A1 describes a superinsulating aluminum layer.

According to a possible definition, the superinsulator material is characterized by its suitability to provide a low-temperature state (being said superinsulating state), in which an electrical resistance of the photosensitive element between said at least two of the electrical contacts amounts to at least 1 MΩ, preferably to at least 10 MΩ or to at least 100 MΩ, for example at a temperature of the photosensitive element of 2 K or at a temperature of the photosensitive element of 1 K.

According to a possible definition, the superinsulator material is characterized by its suitability to provide a low-temperature state (being said superinsulating state), in which an electrical resistance of the photosensitive element between said at least two of the electrical contacts amounts to at least 1 GΩ, preferably to at least 10 GΩ or to at least 100 GΩ, for example at a temperature of the photosensitive element of 0.2 K.

According to some embodiments, the electrical resistance of the superinsulator material changes with temperature (e.g., abruptly and/or by at least a factor of 10) at a phase transition between said low-temperature state/superinsulating state and a higher-temperature state of larger electrical conductivity.

Preferably, the superinsulator material is configured such that a dark current between said at least two of the electrical contacts amounts to no more than 100 fA, for example at a temperature of the photosensitive element of 0.2 K.

Moreover, operating the photodetector device at cryogenic temperatures reduces thermal noise, allowing the device to detect weak photon signals with high precision. This makes the photodetector device particularly suitable for the detection of low light intensities, and potentially even for single-photon detection.

By applying the superinsulator material in the photosensitive element, the photodetector according to this description thus provides at least one or several of the following improvements: an improved response time upon arrival and absorption of a photon, an improved (i.e., shorter) relaxation time of the generated current in the photosensitive element between the electrical contacts, and an improved (i.e., larger) current between the electrical contacts when a photon is absorbed in the photosensitive element.

Here and in the following, the current which the photosensitive element provides between said at least two of the electrical contacts when a photon is absorbed in a section of the photosensitive element underlying said active area, is also referred to as the photocurrent.

The superinsulating state may refer to an electrically superinsulating state.

The active area may be located between the electrical contacts.

The use of a superinsulator also helps to maintain the integrity of the electrical signal by minimizing leakage currents, making use of the extremely high electrical resistance of the superinsulator. This improves the precision and sensitivity of the photodetector further.

According to an embodiment, the photodetector device further comprises a bias-voltage applicator electrically connected to the photosensitive element via a subset of said electrical contacts and adapted to apply a voltage between said subset of the electrical contacts to generate an electric field across the active area to enhance the current provided between the at least two of said electrical contacts when a photon is absorbed in the section of the photosensitive element underlying the active area.

The electric field provided by the bias-voltage applicator across the active area enhances the current provided between the electrical contacts when a photon is absorbed in the photosensitive element. Thus, the sensitivity and efficiency of the photodetector device are improved, as the electric field aids in the swift separation and movement of charge carriers generated by the absorbed photon. This results in a more robust and faster response to incident photons.

In respective embodiments, the subset of the electrical contacts may comprise or be the at least two electrical contacts.

Respective embodiments ensure that the bias voltage is effectively applied across the same contacts that are used for detecting the current generated by photon absorption. This configuration simplifies the electrical design and ensures that the electric field is optimally aligned with the active area where photon absorption occurs, resulting in a streamlined and efficient design, reducing potential losses or inefficiencies in the photodetection process, thereby enhancing the overall performance of the photodetector device.

According to an embodiment, a breakdown voltage is associated with the photosensitive element, the photosensitive element transitioning from a superinsulating state to a state of higher electrical conductivity at said breakdown voltage, wherein the bias-voltage applicator is adapted to apply said voltage between the subset of the electrical contacts with said voltage being in a range of 30% to 70% of the breakdown voltage.

Experiments have demonstrated that a respective choice of the bias voltage significantly improves the sensitivity of the photodetector, without an excessively large risk of fully breaking up the superinsulating state under typical illumination conditions (which would trigger a dead time for further photodetection).

According to an embodiment, the photodetector device further comprises a light-concentration element for concentrating light that impinges on the light-concentration element onto the active area.

Integrating a light-concentration element with the photodetector device enhances the efficiency of light capture by directing more photons onto the active area. This increased photon concentration improves the likelihood of photon absorption by the photosensitive element, thereby generating a stronger electrical signal. The technical improvement lies in the enhanced sensitivity and accuracy of the photodetector device, making it more effective for applications requiring precise photodetection at low temperatures.

Alternatively, or in addition, the light-concentration element may be arranged such that the light which impinges on the light-concentration element is concentrated onto the active area.

The light-concentration element may be shaped and/or have a material composition such that the light which impinges on the light-concentration element is concentrated onto the active area.

Alternatively, or in addition, the light-concentration element may comprise or be a lens or a curved mirror.

Utilizing a lens or a curved mirror as the light-concentration element provides a practical and effective means of focusing light onto the active area.

A phase transition temperature may be associated with the superinsulator material. In respective embodiments, the superinsulator material may be adapted to provide a low-temperature state when a temperature of the superinsulator material is below said phase transition temperature, and the superinsulator material may be adapted to provide a high-temperature state when a temperature of the superinsulator material is above said phase transition temperature. A resistivity of the superinsulator material in the low-temperature state may exceed a resistivity of the superinsulator material in the high-temperature state at least by a factor of 10 or at least by a factor of 100 or at least by a factor of 1000, in particular, wherein said resistivity of the superinsulator material in the low-temperature state may refer to the resistivity of the superinsulator material in the low-temperature state when the temperature of the superinsulator material is 0.2 K below said phase transition temperature and/or wherein said resistivity of the superinsulator material in the high-temperature state may refer to the resistivity of the superinsulator material in the high-temperature state when the temperature of the superinsulator material is 2 K above said phase transition temperature.

According to an embodiment, the superinsulator material comprises or is a material from a group containing titanium nitride, niobium titanium nitride, and indium oxide.

According to some embodiments, the photosensitive element consists of the superinsulator material.

According to an embodiment, a thickness of the photosensitive element does not exceed 10 nm, in particular, wherein the photosensitive element consists of the superinsulator material.

Alternatively, or in addition, the superinsulator material may comprise or be titanium nitride, and a thickness of the photosensitive element may not exceed 5 nm.

Respective embodiments help to ensure the superinsulating properties of the photosensitive element.

According to an embodiment, the photodetector device is adapted for photodetection when the photosensitive element has a temperature below 2 K.

The operability at such low temperatures is a unique feature of the photodetector device according to the disclosure, as has been described in detail above.

Moreover, operating the photodetector device at temperatures below 2 K reduces thermal noise even further. This makes the photodetector device even more suitable for the detection of low light intensities or for single-photon detection.

According to an embodiment, the photodetector device further comprises a cooling element, wherein the cooling element is adapted to cool the photosensitive element to the temperature below 4.2 K, in particular to a temperature below 2K.

According to an embodiment, a length of the active area is at least 1 mm. Alternatively, or in addition, a width of the active area may be at least 5 µm.

This feature ensures that the active area of the photosensitive element is sufficiently large to capture a significant amount of incident photons. By having a length of at least 1 mm, the photodetector device can detect photons over a larger surface area, thereby increasing the likelihood of photon absorption and subsequent current generation. This enhances the sensitivity of the photodetector device. Increasing the width of the active area to at least 5 µm similarly expands the surface area available for photon absorption. This enhancement works in conjunction with the length requirement to further improve the overall photon detection capability of the device. A larger active area width contributes to higher sensitivity.

According to an embodiment, the superinsulator material is obtainable by thinning a superconductor material.

A respective fabrication of the superinsulator material helps to ensure the superinsulating properties of the photosensitive element.

Alternatively, or in addition, the superconductor material may comprise or be titanium nitride or niobium titanium nitride.

The thinning may use etching, in particular plasma etching.

Employing etching, and specifically plasma etching, for the thinning process provides a controlled and precise method to achieve the desired thickness of the superinsulator material. Plasma etching allows for uniform material removal and can be finely tuned to achieve the necessary thinness without damaging the underlying structure.

Alternatively, or in addition, the thinning may be performed to a thickness of 10 nm or less.

A respective fabrication of the superinsulator material helps to ensure the superinsulating properties of the photosensitive element.

According to an embodiment, the superinsulator material of the photosensitive element is in physical contact with a growth promoting layer adapted to promote a highly crystalline growth of the superinsulator material.

The growth promoting layer enhances the crystallinity of the superinsulator material, which can significantly improve the performance of the fabricated photodetector device.

In respective embodiments, the growth promoting layer may be a dielectric growth promoting layer.

A dielectric growth promoting layer can provide electrical insulation while promoting the crystalline growth of the superinsulator material. This dual functionality ensures that the photosensitive element operates efficiently without electrical interference from the growth promoting layer (such as electrical shunting by the growth promoting layer).

The growth promoting layer may comprise or be composed of a nitride, such as aluminum nitride, or an oxide, such as silicon dioxide.

Nitrides and oxides provide excellent growth promoting properties for the superinsulator material.

According to an embodiment, the growth promoting layer is arranged over a substrate, in particular over a dielectric or semiconductor substrate, in particular over a silicon substrate.

According to an embodiment, the photodetector device further comprises an amplifier adapted to amplify said current between said at least two electrical contacts when the photon is absorbed in the section of the photosensitive element underlying said active area.

The inclusion of an amplifier enhances the sensitivity of the photodetector device. By amplifying the current signal generated by the photosensitive element, the device can detect photons more effectively. This results in improved performance in low-light conditions and improves the lower detection limit of the photodetector device.

Alternatively, or in addition, the electrical contacts to the photosensitive element may comprise at least four electrical contacts to the photosensitive element adapted to perform a four-point measurement of a resistivity of the photosensitive element via said at least four electrical contacts.

Having at least four electrical contacts adapted for a four-point measurement of resistivity allows for more precise and accurate determination of the resistivity of the photosensitive element.

Alternatively, or in addition, the photosensitive element may be comprised in a bridge circuit adapted to measure a resistivity of the photosensitive element in comparison to a reference resistor, in particular to measure a change in the resistivity of the photosensitive element in comparison to the reference resistor when the photon is absorbed in the section of the photosensitive element underlying said active area.

This configuration allows for the detection of minute changes in resistivity when a photon is absorbed, enhancing the device's ability to detect small variations in light intensity, providing higher sensitivity.

According to an aspect of the disclosure, a method for fabricating the photodetector device according to any of the embodiments described above is provided. The method comprises providing a superconductor material. The method comprises thinning the superconductor material into a superinsulating layer. The superinsulating layer provides the photosensitive element. The method comprises forming the electrical contacts to the photosensitive element.

Providing a superconductor material involves selecting a material that exhibits superconducting properties at low temperatures. Superconductor materials, such as titanium nitride (TiN) or niobium titanium nitride (NbTiN), are advantageous because they can transition to a superinsulating state, which is the basis of the operation of the photodetector at cryogenic temperatures.

Forming the electrical contacts to the photosensitive element involves creating connections that allow the photodetector to interface with external circuits. These electrical contacts are typically made of conductive materials that ensure minimal resistance and reliable performance. The electrical contacts enable the photodetector to transmit the generated photocurrent or photovoltage to external measurement devices, facilitating accurate detection and analysis of light at ultralow temperatures.

According to an embodiment, the photodetector device according to any of the embodiments described above is used for photodetection, wherein the photosensitive element of the photodetector device has a temperature below 4.2 K.

### LIST OF FIGURES

In the following, a detailed description of the present disclosure and examples thereof is given with reference to the figures, wherein
Figure 1: shows an embodiment of a photodetector device,
Figure 2: shows a graph depicting the current generated in the photosensitive element versus the power of the photons incident onto the active area,
Figure 3: shows a graph with a logarithmic scale illustrating the relationship between the current generated in the photosensitive element and the power of the photons incident onto the active area,
Figure 4: shows a schematic illustration of a photodetector device according to a different embodiment,
Figure 5: shows an illustrative diagram of a voltage-current characteristic curve of the photodetector device, indicating a breakdown voltage,
Figure 6: shows a graph with multiple curves representing the current generated in the photosensitive element for different bias voltages,
Figure 7: shows another embodiment of a photodetector device,
Figure 8: shows another embodiment of a photodetector device,
Figure 9: shows another embodiment of a photodetector device,
Figure 10: shows a schematic flowchart of a method for fabricating the photodetector device according to an embodiment, and
Figure 11a to Fig. 11d: illustrate a method for fabricating the photodetector device according to another embodiment.

### DESCRIPTION OF EXAMPLES

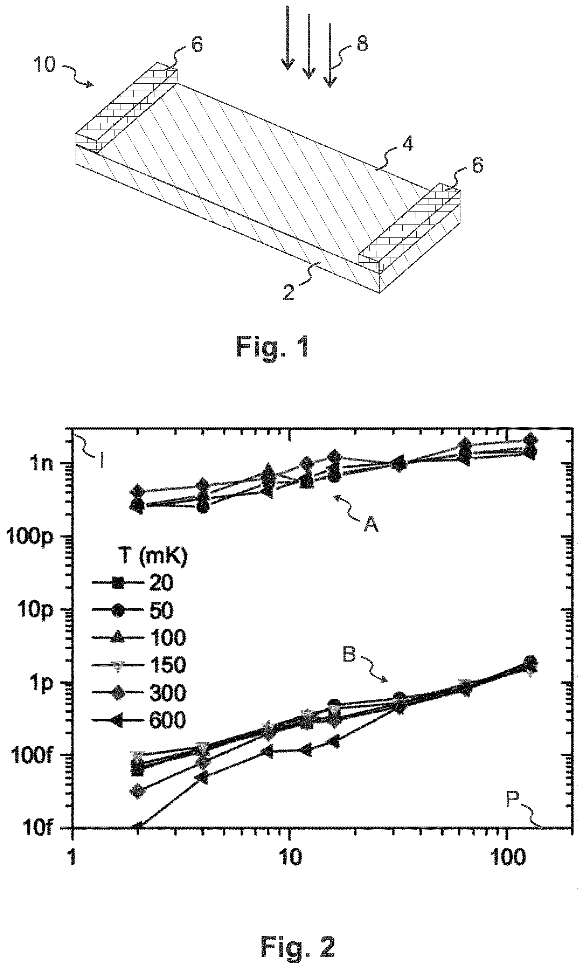

Fig. 1 shows an example of a photodetector device 10 comprising a photosensitive element 2, electrical contacts 6, and an active area 4. Fig. 1 further shows incident photons 8.

When a photon 8 is absorbed in the section of the photosensitive element 2 underlying the active area 4, a current (photocurrent) is generated in the photosensitive element 2 between the electrical contacts 6.

In the depicted embodiment, the photosensitive element 2 is a superinsulator film with a rectangular surface defining a rectangular active area 4. The photosensitive element 2 is composed of a superinsulator material.

The superinsulator material provides a low-temperature, superinsulating state, as described in detail above.

Preferably, a room-temperature electrical resistance (i.e., the electrical resistance at 20°C) of the photosensitive element 2 between the electrical contacts 6 between which the photocurrent is generated amounts to at least 2.5 kΩ, more preferably to at least 3.0 kΩ. According to some embodiments, the room-temperature electrical resistance (i.e., the resistance at 20°C) of the photosensitive element 2 between the electrical contacts 6 between which the photocurrent is generated is in a range from 2.5 kΩ to 5 kΩ.

In the depicted embodiment, the superinsulator material is titanium nitride with a thickness of 4 nm, but another known superinsulator such as niobium titanium nitride or indium oxide or an aluminum layer as described in US 2021/068320 A1 may alternatively be employed. Preferably, the thickness of the superinsulator material, or of the photosensitive element 2, respectively, does not exceed 10 nm. In alternative embodiments (not shown) titanium nitride is used for the superinsulated material, and the thickness of the superinsulated material does not exceed 5 nm.

The superinsulator material is typically obtained by thinning a superconductor material, such as titanium nitride or niobium titanium nitride, using an etching technique like plasma etching. More specifically, the superconductor material, or a layer formed thereof, is initially prepared such that its electrical resistance (in the absence of an external magnetic field) exceeds 2.5 kΩ at room temperature. Then this material is thinned to achieve the room-temperature electrical resistance described above (e.g., above 2.5 kΩ or above 3.0 kΩ or in a range from 2.5 kΩ to 5 kΩ).

Independent of the details of the preparation process, any superinsulator material can be identified by cooling it to a cryogenic temperature and measuring its resistance to determine if the material exhibits said low-temperature state, or superinsulating state, respectively.

For example, for a superinsulator material made from niobium titanium nitride (NbxTiyN) the thickness T of the superinsulator material should be no more than 10 nm. The occurrence of the superinsulating state has been experimentally verified for niobium titanium nitride with a chemical composition NbxTiyN, wherein x is in a range from 0.3 to 0.33, and y is in a range from 0.7 to 0.67. However, it is likely that the superinsulating state occurs for a much wider range of x and y.

In the depicted embodiment, electrical contacts 6 are provided at either end of the photosensitive element 2. These contacts are used for detecting the current generated in the photosensitive element 2 when photons are absorbed therein. The electrical contacts 6 comprise at least one conductive material such as gold, silver, or copper to ensure efficient electrical connection with the photosensitive element 2. The electrical contacts 6 can be fabricated using deposition techniques such as sputtering or evaporation.

According to alternative embodiments (not shown), one of each of the electrical contacts 6 has a shape deviating from a rectangular shape (e.g., round or ellipsoidal).

According to alternative embodiments (not shown) the electrical contacts 6 are spaced apart from each other, but not arranged at the ends of the photosensitive element 2.

The active area 4 is defined by a light-exposable surface of the photosensitive element 2, i.e., a surface of the photosensitive element 2 without any opaque element formed thereover. The active area 4 is where the incident photons 8 are absorbed, leading to the generation of a current in a section of the photosensitive element 2 in the active area 4 between the electrical contacts 6.

According to alternative embodiments (not shown), the active area 4 is modified to include additional structures, such as one or several transparent coatings, in particular an antireflection coating, to further enhance photon absorption in the active area 4, or in the photosensitive element 2, respectively. Respective embodiments improve the sensitivity of the photodetector 10 further.

The inventors have realized that the photodetector device 10 comprising the superinsulator material in the photosensitive element 2 is suitable for detecting photons with a photon wavelength of up to 2 µm.

When an element is referred to as opaque or transparent in the context of this disclosure, this disclosure refers to the opaqueness or the transparency of the respective element at one or several target photon wavelength(s) of the photodetector device 10, each of said target photon wavelength(s) being a photon wavelength of 2 µm or less. According to different embodiments, the target photon wavelength(s) include at least one of the following: 532 nm, 800 nm, 850 nm, 1.32 µm, 1.55 µm.

Absorption of the incident photons 8 by the photosensitive element 2 generates a current in a section of the photosensitive element 2 in the active area 4 between the electrical contacts 6.

The components depicted in Fig. 1 function together to provide a highly sensitive photodetection system operable at cryogenic temperatures (i.e., at a temperature of 4.2 K and below). The superinsulator material of the photosensitive element 2 ensures minimal electrical conductivity in the absence of photon absorption, with an extremely low dark current. Thus, the absorption of even a single photon 8, generating a single free carrier that is no longer in the superinsulating state, provides a sufficient current through the photosensitive element 2 to be detectable on top of this extremely low dark current.

Fig. 2 illustrates a graph showing the current I (in A) generated in the photosensitive element 2 as a function of the power P (in mW) of the incoming photons (having a photon wavelength of 850 nm), at various temperatures (20 mK, 50 mK, 100 mK, 150 mK, 300 mK, and 600 mK) of the photosensitive element 2. Curves A have been measured under illumination of the entire active area 4 of the photosensitive element 2. In other words, the photosensitive element 2 was illuminated with a beam of photons 8, said beam having a cross-sectional area corresponding to the shape of the area 4 and carrying the power P of incoming photons, said beam of photons fully illuminating the active area 4. In the measurement of curve B, the photosensitive element 2 was illuminated with a beam of photons carrying the same power P of incoming photons, but with a smaller cross-sectional area, such that the beam of photons illuminated only a part of the active area 4.

In either of the situations illustrated by the curves A and B, the current I increases in an approximately linear way with the power P of incoming photons, as is desirable for a photodetector.

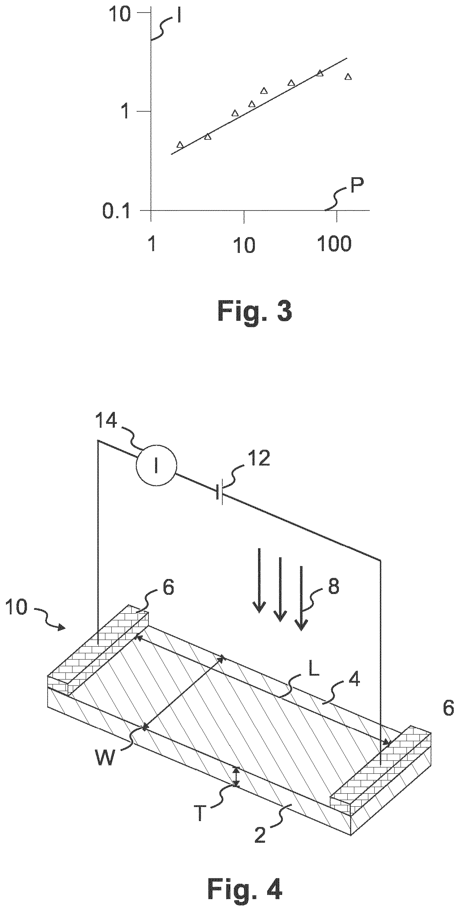

Fig. 3 shows a graph illustrating the relationship between the power P (in µW) of incoming photons the current I (in nA) generated in the photosensitive element 2 of the photodetector device 10 in response to said power P of incoming photons, on a double logarithmic scale. The photons had a photon wavelength of 850 nm. The graph further demonstrates the linear relationship between the generated current I and the power P of the incoming photons.

Fig. 4 illustrates a photodetector device 10 according to another embodiment. The photodetector device 10 according to the depicted embodiment is generally similar to the photodetector 10 described above, with the modifications laid out below. Similar components are indicated with reference numerals identical to the ones used previously. For the sake of brevity, the corresponding components will not be described again, but reference is made to their detailed description above. The following description focuses on the modifications introduced in the embodiment of Fig. 4. Those modifications are applicable to the photodetector device 10 according to any of the embodiments described in this disclosure.

In Fig. 4, a length L, a width W, and a thickness T of the photosensitive element 2 are indicated.

The photodetector device 10 according to the embodiment of Fig. 4 comprises a bias-voltage applicator 12 electrically connected to the photosensitive element 2 via some of the electrical contacts 6.

The bias-voltage applicator 12 is used to apply a voltage across the photosensitive element 2 via some of the electrical contacts 6. This voltage generates an electric field across the active area 4, enhancing the current produced when photons 8 are absorbed in the active area 4. For the bias-voltage applicator 12 a voltage source capable of providing a stable and precise voltage is used.

Fig. 4 also shows a current measurement device 14 connected to the photosensitive element 2 via some of the electrical contacts 6 to measure the photocurrent (i.e., the current generated in the section of the photosensitive element 2 between the respective electrical contacts 6 when a photon 8 is absorbed in a section of the photosensitive element 2 underlying said active area).

In the depicted embodiment, the photodetector device 10 comprises two electrical contacts 6, which are used both for connecting the bias-voltage applicator 12, and for connecting the current measurement device 14. According to alternative embodiments (not shown), one set of electrical contacts 6 is provided for connecting the bias-voltage applicator 12, and another set of electrical contacts 6 is provided for connecting the current measurement device 14.

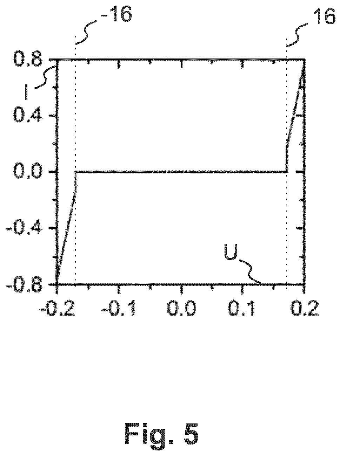

Fig. 5 illustrates a graph depicting the current I (in nA) through a superinsulator material for a photosensitive element of a photodetector device when a voltage U (in Volts V) is applied to the respective superinsulator material.

A breakdown voltage 16 of the superinsulator material is indicated on the graph, showing the point at which the current through the superinsulator material exhibits a sharp increase, indicating the transition from the superinsulating state to a state of higher electrical conductivity.

The described operation of a photosensitive element 2 comprising the superinsulator material relies on the superinsulator being in the superinsulating state.

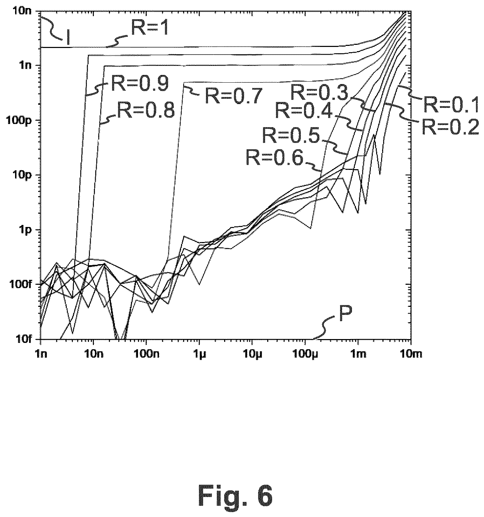

Fig. 6 shows a graph illustrating the current I generated upon photon absorption in the photosensitive element 2 for incoming photons with an overall power P on the active area 4. During the measurement of the depicted currents I, a bias voltage was applied to the photosensitive element 2 using a bias-voltage applicator 12 as described above. Indicated in Fig. 6 is the relative applied bias voltage R, i.e., the bias voltage relative to the breakdown voltage 16 of the superinsulator material of the photosensitive element 2. For example, R = 0.2 indicates the application of a bias voltage amounting to 20% of the breakdown voltage 16 during the measurement of the current I.

To ensure that the superinsulator material of the photosensitive element 2 remains in the superinsulating state, the bias voltage (applied using the bias-voltage applicator 12 as described above) is preferably kept at 70% of the breakdown voltage 16 or below. A bias voltage of at least 30% is beneficial to significantly enhance the current in the active region 4.

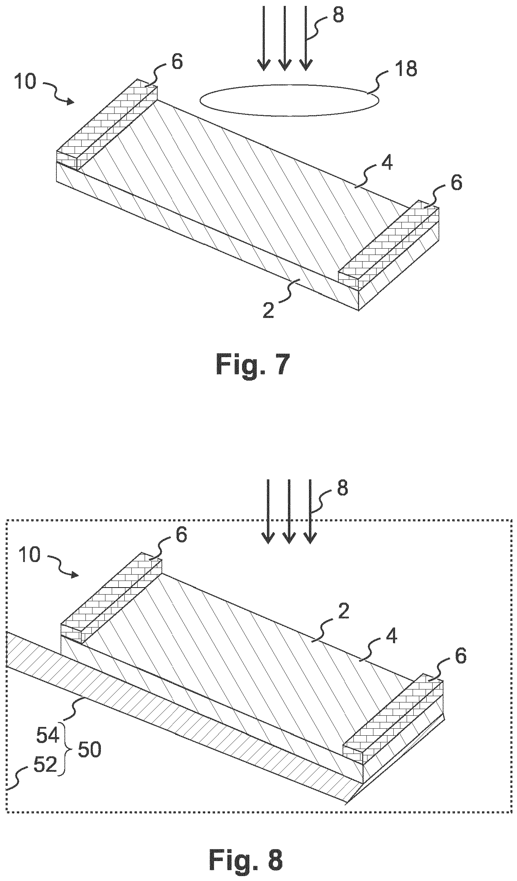

Fig. 7 illustrates a photodetector device 10 according to another embodiment. The photodetector device 10 according to the depicted embodiment is generally similar to the photodetector 10 described above, with the modifications laid out below. Similar components are indicated with reference numerals identical to the ones used previously. For the sake of brevity, the corresponding components will not be described again, but reference is made to their detailed description above. The following description focuses on the modifications introduced in the embodiment of Fig. 7. Those modifications are applicable to the photodetector device 10 according to any of the embodiments described in this disclosure.

The photodetector device 10 according to the embodiment of Fig. 7 comprises a light-concentration element 18. The light-concentration element 18 is used to focus incoming photons 8 onto the active area 4. In the depicted embodiment, the light-concentration element 18 is a lens. In alternative embodiments (not shown) it takes the form of a curved mirror.

According to various embodiments, the light-concentration element 18 is composed of glass or a transparent plastic. In various embodiments, at least one of its surfaces has a shape such as a spherical shape or a parabolic shape.

Preferably, the light-concentration element 18 is arranged such that the active area 4 is in the focus of the light-concentration element 18.

The light-concentration element 18 improves the sensitivity of the photodetector device 10.

Fig. 8 illustrates a photodetector device 10 according to another embodiment. The photodetector device 10 according to the depicted embodiment is generally similar to the photodetector 10 described above, with the modifications laid out below. Similar components are indicated with reference numerals identical to the ones used previously. For the sake of brevity, the corresponding components will not be described again, but reference is made to their detailed description above. The following description focuses on the modifications introduced in the embodiment of Fig. 8. Those modifications are applicable to the photodetector device 10 according to any of the embodiments described in this disclosure.

The photodetector device 10 according to the embodiment of Fig. 8 comprises a cooling element 50.

In the depicted embodiment, the cooling element 50 comprises a vacuum cryostat 52 enclosing the photosensitive element 2, and comprises a cold finger 54 in contact with the photosensitive element 2. The cold finger 54 is in thermal contact with liquid helium. More specifically, the cold finger 54 has a thermal connection to a flow channel through which liquid helium flows.

The cooling element 50 is designed to cool the photosensitive element 2 to a cryogenic temperature, ensuring that the superinsulator material of the photosensitive element 2 is in the superinsulating state. The cold finger 54 typically comprises a material with high thermal conductivity, such as copper or aluminum, to efficiently transfer heat away from the photosensitive element 2.

The embodiment of Fig. 8 implements the operation of the photodetector device 10 at the cryogenic temperature.

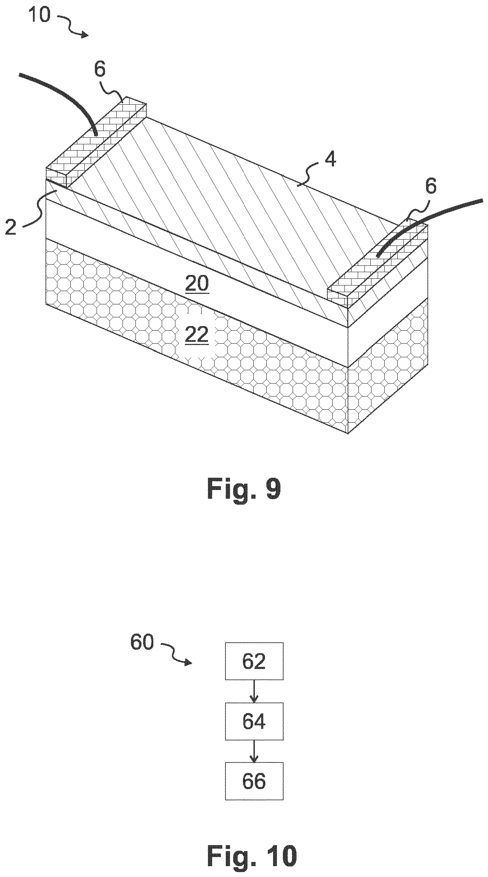

Fig. 9 illustrates a photodetector device 10 according to another embodiment. The photodetector device 10 according to the depicted embodiment is generally similar to the photodetector 10 described above in the context of any of the previous embodiments, with the modifications laid out below. Similar components are indicated with reference numerals identical to the ones used previously. For the sake of brevity, the corresponding components will not be described again, but reference is made to their detailed description above. The following description focuses on the modifications introduced in the embodiment of Fig. 10. Those modifications are applicable to the photodetector device 10 according to any of the embodiments described in this disclosure.

In the embodiment of Fig. 9, the superinsulator material of the photosensitive element 2 is arranged over a growth promoting layer 20. The growth promoting layer 20 in turn is placed over a substrate 22.

The growth promoting layer 20 is designed to promote a highly crystalline growth of the superinsulator material of the photosensitive element 2 thereon, or of a superconductor material 68, respectively, which said superinsulator material is subsequently fabricated from. An exemplary growth promoting layer 20 is made from aluminum nitride or silicon dioxide.

According to alternative embodiments (not shown), the growth promoting layer 20 can be composed of other dielectric materials that promote crystalline growth, such as hafnium oxide or zirconium oxide.

The advantages of using a growth promoting layer 20 include improved crystalline quality of the superinsulator material, which enhances the photodetector's sensitivity and efficiency.

The substrate 22 provides mechanical support to the entire structure of the photodetector device 10. It is typically made from dielectric or semiconductor materials, such as silicon. The substrate 22 ensures the stability and integrity of the device.

According to alternative embodiments (not shown), the substrate 22 can be made from other materials such as sapphire or gallium arsenide, depending on the specific application requirements.

The advantages of using a suitable substrate 22 include enhanced mechanical stability and compatibility with various fabrication processes.

Fig. 10 illustrates an example of a method 60 for fabricating the photodetector device 10. The method 60 includes providing 62 a superconductor material 68, thinning 64 the superconductor material 68 into a superinsulating layer the superinsulating layer providing the photosensitive element 2, and forming 66 the electrical contacts 6 to the photosensitive element 2.

According to some embodiments, the step of providing 62 a superconductor material 68 involves selecting an appropriate superconductor material such as titanium nitride, niobium titanium nitride, or indium oxide.

According to some embodiments, the step of thinning 64 the superconductor material involves application of an etching technique such as plasma etching. The resulting superinsulating layer forms the photosensitive element 2.

The advantages of the thinning process 64 include achieving the precise thickness required for the superinsulating layer.

According to some embodiments, the step of forming 66 the electrical contacts 6 involves a structured deposition of at least one conductive material, such as a metal. The structured deposition is achieved using a technique such as photolithography or electron beam lithography.

According to alternative embodiments, the electrical contacts 6 are formed using other methods such as screen printing or inkjet printing.

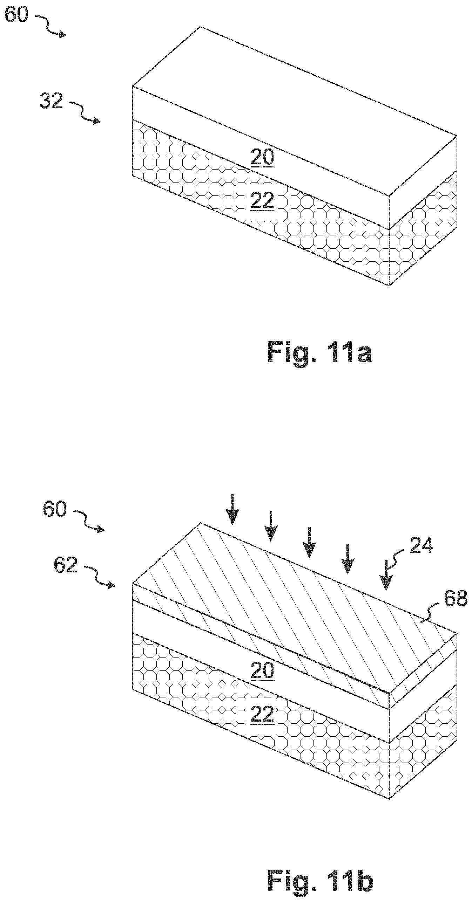

Fig. 11a to Fig. 11d illustrate an embodiment of a method 60 for fabricating a photodetector device.

Fig. 11a shows the provision 32 of an initial structure 32, which includes a growth promoting layer 20 arranged over a substrate 22. The growth promoting layer 20 is adapted to promote a highly crystalline growth of the superinsulator material. The substrate 22 can be a dielectric or semiconductor substrate, such as a silicon substrate.

The growth promoting layer 20 is typically composed of a nitride, such as aluminum nitride, or an oxide, such as silicon dioxide. This layer serves to enhance the crystalline structure of the subsequently deposited superconductor material and/or superinsulator material, ensuring optimal performance of the photodetector device. In the specific depicted example, the substrate 22 is a silicon substrate with a silicon oxide layer 20 thereover.

The use of a silicon substrate 22 is particularly beneficial due to its widespread availability and compatibility with existing semiconductor fabrication processes.

According to alternative embodiments (not shown), the growth promoting layer 20 is composed of other materials that can promote crystalline growth, such as other nitrides or oxides. The substrate 22 may also be made from other semiconductor materials, such as gallium arsenide or germanium.

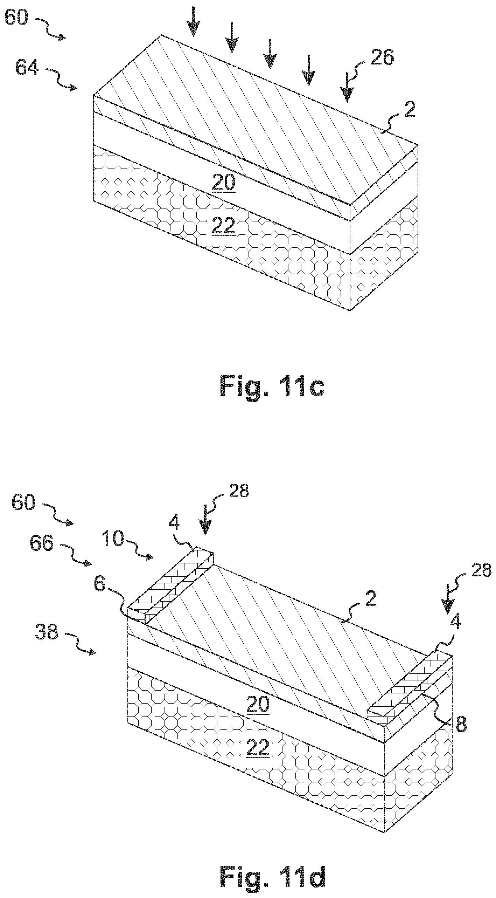

Fig. 11b and Fig.11c illustrate the subsequent steps in the fabrication process, namely in Fig. 11b the process step of providing 62 a superconductor material 68, and then in Fig. 11c the process step of thinning 64 the superconductor material 68 to form a superinsulating layer 2. The deposition 24 of the superconductor material 68 applies physical vapor deposition or chemical vapor deposition of TiN, optionally with a co-deposition of niobium if NbTiN is to be used for the superinsulator materials. The subsequent thinning process 26 uses an etching technique, more specifically plasma etching 26, and reduces the thickness of the superconductor material 68 to achieve the desired superinsulating properties of the resulting layer 2. The resulting superinsulating layer 2 forms the photosensitive element of the photodetector device.

The superconductor material 68 can be titanium nitride or niobium titanium nitride. Both materials comprise titanium nitride, however, with a partial substitution of the titanium for niobium in the niobium titanium nitride. The thinning process 24 ensures that the thickness of the superinsulating layer 62 does not exceed 10 nm, with a preferred thickness of 5 nm for pure titanium nitride.

The thinning process 26 ensures that the superinsulating properties are achieved.

Fig. 11d illustrates the formation 66 of the electrical contacts 6. The formation 66 of the electrical contacts 6 uses a structured deposition 28 (e.g., photolithography or electron beam lithography) of at least one conductive material, such as a metal (e.g., gold or platinum). The contacts can be arranged in a shape different from the depicted rectangular one, depending on the specific design of the photodetector device 10.

The examples of the present disclosure disclosed herein only constitute specific examples for illustration purposes. The present invention can be implemented in various ways and with many modifications without altering the underlying basic properties. Therefore, the present invention is only defined by the claims as stated below.

## Claims

1. A photodetector device (10) for photodetection when a photosensitive element (2) of the photodetector device (10) has a temperature below 4.2 K, the photodetector device (10) comprising:
said photosensitive element (2), at least a portion of a surface of the photosensitive element (2) defining an active area (4) of the photodetector device (10); and
electrical contacts (6) to the photosensitive element (2);
wherein the photosensitive element (2) is adapted to provide a current between at least two of said electrical contacts (6) when a photon (8) is absorbed in a section of the photosensitive element (2) underlying said active area (4);
**characterized in that** the photosensitive element (2) comprises a superinsulator material.

2. The photodetector device (10) according to claim 1, further comprising a bias-voltage applicator (12) electrically connected to the photosensitive element (2) via a subset of said electrical contacts (6) and adapted to apply a voltage between said subset of the electrical contacts (6) to generate an electric field across the active area (4) to enhance the current provided between the at least two of said electrical contacts (6) when a photon (8) is absorbed in the section of the photosensitive element (2) underlying the active area (4), in particular, wherein the subset of the electrical contacts (6) comprises or is the at least two electrical contacts (6).

3. The photodetector device (10) according to claim 2, wherein a breakdown voltage (16) is associated with the photosensitive element (2), the photosensitive element (2) transitioning from a superinsulating state to a state of higher electrical conductivity at said breakdown voltage (16), and wherein the bias-voltage applicator (12) is adapted to apply said voltage between the subset of the electrical contacts (6) with said voltage being in a range of 30% to 70% of the breakdown voltage (16).

4. The photodetector device (10) according to any of the preceding claims, further comprising a light-concentration element (18) for concentrating light that impinges on the light-concentration element (18) onto the active area (4), in particular, wherein the light-concentration element (18) is arranged such that the light which impinges on the light-concentration element (18) is concentrated onto the active area (4) and/or wherein the light-concentration element (18) is shaped and/or has a material composition such that the light which impinges on the light-concentration element (18) is concentrated onto the active area (4) and/or wherein the light-concentration element (18) comprises or is a lens or a curved mirror.

5. The photodetector device (10) according to any of the preceding claims,
wherein a phase transition temperature is associated with the superinsulator material, wherein the superinsulator material is adapted to provide a low-temperature state when a temperature of the superinsulator material is below said phase transition temperature, and the superinsulator material is adapted to provide a high-temperature state when a temperature of the superinsulator material is above said phase transition temperature, and
wherein a resistivity of the superinsulator material in the low-temperature state exceeds a resistivity of the superinsulator material in the high-temperature state at least by a factor of 10 or at least by a factor of 100 or at least by a factor of 1000,
in particular, wherein said resistivity of the superinsulator material in the low-temperature state refers to the resistivity of the superinsulator material in the low-temperature state when the temperature of the superinsulator material is 0.2 K below said phase transition temperature and/or wherein said resistivity of the superinsulator material in the high-temperature state refers to the resistivity of the superinsulator material in the high-temperature state when the temperature of the superinsulator material is 2 K above said phase transition temperature.

6. The photodetector device (10) according to any of the preceding claims, wherein the superinsulator material comprises or is a material from a group containing titanium nitride, niobium titanium nitride, and indium oxide, in particular, wherein the photosensitive element (2) consists of the superinsulator material.

7. The photodetector device (10) according to any of the preceding claims, wherein a thickness (T) of the photosensitive element (2) does not exceed 10 nm, in particular; in particular, wherein the superinsulator material comprises or is titanium nitride, and a thickness (T) of the photosensitive element (2) does not exceed 5 nm.

8. The photodetector device (10) according to any of the preceding claims, further comprising a cooling element (50), wherein the cooling element (50) is adapted to cool the photosensitive element (2) to the temperature below 4.2 K, in particular to a temperature below 2K.

9. The photodetector device (10) according to any of the preceding claims,
wherein a length (L) of the active area (4) is at least 1 mm and/or wherein a width of the active area (4) is at least 5 µm; and/or
wherein the photodetector device (10) is adapted for photodetection when the photosensitive element (2) has a temperature below 2 K.

10. The photodetector device (10) according to any of the preceding claims, wherein the superinsulator material is obtainable by thinning a superconductor material (68), in particular wherein the superconductor material (68) comprises or is titanium nitride or niobium titanium nitride and/or wherein the thinning uses etching (26), in particular plasma etching (26), and/or wherein the thinning is performed to a thickness of 10 nm or less.

11. The photodetector device (10) according to any of the preceding claims, wherein the superinsulator material of the photosensitive element (2) is in physical contact with a growth promoting layer (20) adapted to promote a highly crystalline growth of the superinsulator material, in particular wherein the growth promoting layer (20) is a dielectric growth promoting layer (20); in particular, wherein the growth promoting layer (20) comprises or is composed of a nitride, such as aluminum nitride, or an oxide, such as silicon dioxide.

12. The photodetector device (10) according to claim 10 or claim 11, wherein the growth promoting layer (20) is arranged over a substrate (22), in particular over a dielectric or semiconductor substrate (22), in particular over a silicon substrate (22).

13. The photodetector device (10) according to any of the preceding claims,
wherein the photodetector device (10) further comprises an amplifier adapted to amplify said current between said at least two electrical contacts (6) when the photon (8) is absorbed in the section of the photosensitive element (2) underlying said active area (4); and/or
wherein the electrical contacts (6) to the photosensitive element (2) comprise at least four electrical contacts (6) to the photosensitive element (2) adapted to perform a four-point measurement of a resistivity of the photosensitive element (2) via said at least four electrical contacts (6); and/or
wherein the photosensitive element (2) is comprised in a bridge circuit adapted to measure a resistivity of the photosensitive element (2) in comparison to a reference resistor, in particular to measure a change in the resistivity of the photosensitive element (2) in comparison to the reference resistor when the photon is absorbed in the section of the photosensitive element (2) underlying said active area (4).

14. A method (60) for fabricating the photodetector device (10) according to any of the preceding claims, the method (60) comprising:
providing (62) a superconductor material (68);
thinning (64) the superconductor material (68) into a superinsulating layer, the superinsulating layer providing the photosensitive element (2); and
forming (66) the electrical contacts (6) to the photosensitive element (2).

15. Use of the photodetector device (10) according to any of claims 1 to 13 for photodetection, wherein the photosensitive element (2) of the photodetector device (10) has a temperature below 4.2 K, preferably below 2 K.
